# EUROPÄISCHE PATENTANMELDUNG

(11) **EP 1 967 501 A1**
(43) Veröffentlichungstag der Anmeldung: **10.09.2008**
(21) Anmeldenummer: 07103761.8
(22) Anmeldetag: 08.03.2007
(51) Int. Cl.: C03C 17/36

(54) **Temperbare Glasbeschichtung**

(71) Anmelder: Applied Materials, Inc., Santa Clara, CA 95054 (US)
(72) Erfinder: List, Matthias, 01127, Dresden (DE); Kleideiter, Gerd, 48683, Ahaus (DE); Schreiber, Udo, 63637, Jossgrund (DE); Schramm, Sven, 97070, Würzburg (DE)
(74) Vertreter: Schickedanz, Willi

(57) **Zusammenfassung**

Die Erfindung betrifft eine Silber-Low-E-Beschichtung für Glas, die temperbar ist und mittels Sputterprozessen auf das Glas aufgebracht werden kann. Bei den einzelnen Schichten der Beschichtung handelt es sich um kostengünstige Standard-Materialien. Eine Ausführungsform der Erfindung besteht beispielsweise aus einem Glas-Substrat, einer darauf befindlichen Si₃N₄-Schicht von etwa 15 nm Dicke, einer TiO₂-Schicht von 15 nm Dicke auf der Si₃N₄-Schicht, einer 12,5 nm dicken Ag-Schicht, die sich auf der TiO₂-Schicht befindet, einer NiCrOₓ-Schicht von etwa 5 nm Dicke, die sich auf der Ag-Schicht befindet, und einer abschließenden 45 nm dicken Si₃N₄-Schicht.

## Beschreibung

Die Erfindung betrifft eine temperbare Glasbeschichtung nach dem Oberbegriff des Patentanspruchs 1.

Beschichtungen auf transparentem Glas oder transparentem Kunststoff dienen dazu, bestimmte Wellenlängen oder Wellenlängenbereiche des auftreffenden Lichts zu reflektieren oder zu absorbieren. Bekannt sind Beschichtungen auf optischen Linsen und auf Fensterscheiben, auch Architekturglas genannt, sowie die Beschichtungen auf Kfz-Fensterscheiben.

Die wichtigste Funktion einer Beschichtung auf Architekturglas besteht darin, Wärmestrahlen zu reflektieren, damit sich ein Raum im Sommer nicht zu sehr erwärmt und im Winter nicht zu sehr abkühlt. Das sichtbare Licht soll dabei aber möglichst nicht geschwächt werden, d. h. die Beschichtung soll eine hohe Transmission im sichtbaren Bereich (ca. 400 nm bis 700 nm bei Tagessehen und ca. 390 nm bis 650 nm bei Nachtsehen) und eine hohe Reflexion für Wärme- und Infrarotstrahlen (Wellenlänge > 700 nm) aufweisen.

Schichtsysteme, welche diese Funktion erfüllen, werden Low-E-Schichtsysteme genannt, wobei "E" für "emissivity" (= Emissionsgrad oder Emissionsvermögen) steht. Es soll damit zum Ausdruck gebracht werden, dass diese Schichtsysteme nur wenig Wärmestrahlung aus einem Gebäuderaum ins Freie abgeben.

Eine Wärmeregulierung wird in der Regel dadurch erreicht, dass auf Glas elektrisch hochleitende Schichten, häufig ein Metall wie Cu, Ag, Au mit einer sehr niedrigen Strahlungsemissionskoeffizienz aufgebracht werden.

Wegen der oft zu hohen Lichtreflexion dieser Low-E-Schichten werden diese Schichten mit Hilfe von zusätzlichen transparenten Schichten bisweilen entspiegelt. Durch das Aufbringen der transparenten Schichten kann auch der gewünschte Farbton der Glasscheibe eingestellt werden.

Es ist bereits ein beschichtetes Substrat bekannt, das mindestens eine metallische Beschichtungsschicht und weitere dielektrische Schichten aufweist (EP 1 089 941 B1). Dieses beschichtete Substrat ist so aufgebaut, dass es getempert und gebogen werden kann.

Weiterhin ist ein mit einem Mehrschichtsystem versehenes Substrat bekannt, das ebenfalls temper- und biegbar ist (US 6 576 349 B2, US 6 686 050 B2). Das hierbei verwendete Mehrschichtsystem verfügt dabei über zwei Schichten, die Infrarotstrahlung reflektieren und die von jeweils zwei NiCrOₓ-Schichten umgeben sind.

Ferner ist ein wärmedämmendes Schichtsystem bekannt, das nach der Beschichtung getempert und gebogen wird (DE 198 50 023 A1 bzw. EP 0 999 192 B1). Dieses Schichtsystem weist eine Edelmetallschicht auf, die auf einer TiO₂-Schicht angeordnet ist, wobei die beiden Schichten von unteroxidischem NiCrO₂ umgeben sind.

Schließlich sind auch noch temperbare Beschichtungen bekannt, die unterstöchiometrische SiₓN_{y} bzw. SiNₓO_{y} verwenden (WO 2005/19127 A1, WO 2005/034192 A2).

Hergestellt werden die verschiedenen Schichten in der Regel mit Hilfe von SputterVerfahren, bei welchen aus so genannten Targets mittels positiver Ionen Teilchen herausgeschlagen werden, die sich dann auf dem Substrat, das Architekturglas sein kann, niederschlagen.

Die bekannten Schichtsysteme weisen mindestens eine der nachfolgend erwähnten Nachteile auf:
- teure oder exotische Ausgangsmaterialien für Sputter-Targets
- komplexe und aufwändige Prozessführung
- komplexer Schichtaufbau
- unzureichende optische Eigenschaften
- starke Veränderung der wesentlichen Eigenschaften des beschichteten Glases durch einen Temperprozess

Der Erfindung liegt die Aufgabe zugrunde, eine einfache und kostengünstige Silber-Low-E-Beschichtung zu schaffen, welche ihre wesentlichen Eigenschaften nach einem Tempern nur geringfügig verändert.

Diese Aufgabe wird mit den Merkmalen des Patentanspruchs 1 gelöst.

Der mit der Erfindung erzielte Vorteil besteht insbesondere darin, dass nur Standard-Targetmaterialien wie mit Bor dotiertes Silizium (Si:B) oder mit Titan dotiertes Silizium-Aluminium (SiAI:Ti) sowie Titanoxid, Silber oder Nickel-Chrom zum Einsatz kommen.

Da reines Silizium nicht leitfähig ist, müssen Silizium-Sputter-Targets beispielsweise mit Bor dotiert sein, damit sie überhaupt zum DC- oder MF-Sputtern eingesetzt werden können. Die Zusatzstoffe Bor, Aluminium oder Titan, die auch in der Schicht enthalten sind, wirken sich nicht störend aus. Si₃N₄ enthält als Schichtmaterial nur geringe Mengen an Sauerstoff (Oₘ).

Nachfolgend werden die Prozessparameter eines durchgeführten Sputterprozesses bei der Herstellung der erfindungsgemäßen Beschichtung Si₃N₄ - TiO₂ - Ag - NiCrOₓ - Si₃N₄ auf Glas tabellarisch wiedergegeben. Die verwendeten Bezeichnungen bedeuten hierbei Folgendes:
- KT =: Kathode
- sccm =: Standard-Kubikzentimeter pro Minute (auch Nml pro Minute; Nml = Norm-Millimeter)
- AC =: Wechselstrom
- DC =: Gleichstrom
- V =: Volt (Spannung)
- A =: Ampere (Strom)
- W =: Watt (Leistung)
- k =: 1000
- µ =: 10⁻⁶
- bar =: 0,1 MPa = 10⁵ Pa (Pa = Pascal = Druck)
- planar =: planare Kathode
- rot =: rotierende Kathode
- : =: Dotierung mit
- KT 1, KT 2 etc.: sind dabei die verschiedenen Kathoden eines Inline-Prozesses, an denen ein Substrat - hier Glas - nacheinander vorbeibewegt wird.
- m =: Zahl größer oder gleich Null

**Tabelle 1**

| Kathode | KT 1 | KT 2 | KT 3 | KT 4 | KT 5 | KT 6 | KT 7 | KT 8 |
|---|---|---|---|---|---|---|---|---|
| Material | **Si₃N₄** | **TiO₂** | **TiO₂** | **TiO₂** | **Ag** | **NiCrOₓ** | **Si₃N₄:Oₘ** | **Si₃N₄:Oₘ** |
| Gaseinlass | | | | | | | | |
| Argon | 700 sccm | 500 sccm | 450 sccm | 450 sccm | 590 sccm | 480 sccm | 1000 sccm | 1000 sccm |
| Sauerstoff | 20 sccm | 293 sccm | 274 sccm | 265 sccm | 10 sccm | 40 sccm | 50 sccm | 50 sccm |
| Stickstoff | 585 sccm | 50 sccm | 50 sccm | 50 sccm | 0 sccm | 0 sccm | 1070 sccm | 1195 sccm |
| | | | | | | | | |
| Prozess | AC rot | AC rot | AC rot | AC rot | DC planar | DC planar | AC rot | AC rot |
| Druck | 4,91 µbar | 4,22 µbar | 4,36 µbar | 4,15 µbar | 4,34 µbar | 4,65 µbar | 8,83 µbar | 9,23 µbar |
| | | | | | | | | |
| Spannung | 340,0 V | 448,0 V | 446,0 V | 447,0 V | 408,0 V | 458,0 V | 265,0 V | 266,0 V |
| Strom | 102,0 A | 223,0 A | 224,0 A | 225,0 A | 7,0 A | 6,5 A | 223,0 A | 222,0 A |
| Leistung | 35,0 kW | 100,0 kW | 100,0 kW | 100,0 kW | 2,7 kW | 2,9 kW | 59,0 kW | 59,0 kW |

Die TiO₂-Schicht hat hierbei eine Doppelfunktion als entspiegelndes Dielektrikum und als Seedlayer bzw. Blocker für die nachfolgende Silberschicht. Das Auftragen der TiO₂-Schicht in drei Schichten (KT 2, KT 3, KT 4) erfolgt deshalb, weil bei vorgegebener Substratgeschwindigkeit nur eine Kathode nicht die ausreichende Schichtdicke erbringen würde. Aus dem gleichen Grund wird die Si₃N₄:Oₘ-Schicht in zwei Schritten aufgebracht.
Keine der Schichten wies vor dem Tempern einen Gradienten auf. Auf spezielle Dotierungen wurde bei dem Targetmaterial des Sputterprozesses verzichtet.

Die dielektrischen Schichten - Si₃N₄ und TiO₂ - werden vorzugsweise von rotierenden Magnetrons gesputtert. Für die TiO₂-Schicht können keramische TiOₓ-Targets verwendet werden, die sowohl per MF-Technik (ca. 10 kHz bis 80 kHz) oder AC-Technik oder auch per DC-Technik gesputtert werden können.

Die Ag-Schicht und die NiCrOₓ-Schichten werden üblicherweise von metallischen Targets mittels DC-Technik gesputtert. Für alle Prozesse sind planare und/oder rotierende Targets denkbar. Für TiO₂- und Si₃N₄-Beschichtungen werden seit einiger Zeit vorzugsweise rotierende Targets verwendet. Bei Ag- und NiCrOₓ-Schichten sind planare Targets Standard, aber auch rotierende Targets sind möglich.

Wie man der Tabelle 1 entnehmen kann, werden nur geringe Mengen Sauerstoff bei den Si₃N₄-Prozessen benötigt. Bei dem abschließenden Si₃N₄ ist ein hoher Druck erforderlich. Statt Si₃N₄:O kann allgemein auch SiₓN_{y}O_{z} geschrieben werden, wobei x/y ≤ 0,75 und y/z > 4 gilt. Der maximale Sauerstofffluss für den NiCrOₓ-Prozess tritt auf dem Metall-Ast der Hysteresis auf, wozu enge Blenden und ein Gaseinlass unterhalb dieser Blende in der Sputterkammer Voraussetzung sind.

Aus den rechten Spalten der Tabelle 1 können Verhältnisse N₂ : O₂ ≥ 20 : 1 entnommen werden. Die Schichten können jedoch auch z. B. bei einem Gasflussverhältnis N₂ : O₂ = 4 : 1 erzeugt werden. Das Gasflussverhältnis von N₂ : O₂ spiegelt sich nicht in diesem Verhältnis in der Schichtzusammensetzung wieder. Es wirken vielmehr verschiedene Einflussparameter mit, wenn sich relativ mehr Sauerstoff als Stickstoff in den Schichten wieder findet.

Unter dem Metall-Ast der Hysteresis wird Folgendes verstanden: Trägt man die Kennlinie bei konstanter Leistung und zunehmendem Sauerstofffluss gegen die Generatordaten (Strom, Spannung) auf, so steigt die Spannung bis zu einem gewissen Punkt, dem Kipppunkt. Erhöht man dann die Sauerstoffmenge weiter, so fällt die Spannung deutlich ab. Der Prozess ist vom Metall-Mode in den Oxid-Mode gekippt. Verringert man den Sauerstoff wieder, so erreicht man einen Punkt, an dem der Prozess wieder in den Metall-Mode zurückkippt. Die beiden Kipppunkte sind jedoch nicht gleich, vielmehr beschreibt die Kurve eine Hysterese (vgl. Fig. 1 der EP 0 795 890 A2).

Die geringen Mengen an Stickstoff bei den TiO₂-Prozessen sind an sich nicht ungewöhnlich und beim Einsatz von metallischen Targets zur Prozessstabilisierung üblich. Beim Einsatz von keramischen Targets kann auf den Stickstoff verzichtet werden. Wahrscheinlich stehen durch den höheren Druck und den Sauerstoff bei der obersten Schicht aus Si₃N₄ : O zwei Parameter zur Verfügung, die eine auf die Beschichtung und die Beschichtungsanlage abgestimmte Einstellung der Barrierewirkung und/oder der internen mechanischen Schichtspannung erlauben.

In analoger Weise gilt dies auch für die Si₃N₄-Grundschicht (KT 1), aber hier hat der erhöhte Sputterdruck keine Vorteile zur Folge.

Mit der kontinuierlichen Variation von Sauerstofffluss und Arbeitsdruck bei den beiden Si₃N₄-Prozessen (KT 1 bzw. KT 7 und KT 8) hat man variable Parameter (also gewissermaßen Stellhebel), um das Schichtsystem auf den jeweiligen Temperprozess anzupassen. Es steht also ein "Tuningbereich" zur Verfügung, um für die jeweilige Beschichtungsanlage, Glasqualität und Weiterverarbeitung (speziell das Tempern) eine optimale Anpassung auf Seiten der Beschichtung zu erzielen.

Die in der Tabelle 1 angegebene Schichtkombination hat vor und nach dem Tempern die in der nachfolgenden Tabelle 2 wiedergegebenen Eigenschaften. Hierbei bedeuten die verwendeten Symbole und Kürzel des CIE-LAB-Farbsystems Folgendes:
- a* =: Farbwert auf der Rot-Grün-Achse (dimensionslos)
- b* =: Farbwert auf der Gelb-Blau-Achse (dimensionslos)
- Ty =: die im sichtbaren Bereich gemittelte Transmission in Prozent
- RGy =: die im sichtbaren Bereich gemittelte Reflexion von der Glasseite der Probe in Prozent
- Rfy =: die im sichtbaren Bereich gemittelte Reflexion von der Schichtseite der Probe in Prozent
- Haze =: Trübung oder "Milchigkeit" (Streulichtverluste), Streulichtanteil in %
- R/sq =: Flächenwiderstand in Ohm (vgl. Hans Joachim Glaser: Dünnfilmtechnologie auf Flachglas, S. 134 - 137)

Die Dicke der ersten Si₃N₄-Schicht beträgt vorzugsweise 5 bis 25 nm. Die zweite Schicht aus TiO₂ hat vorzugsweise ebenfalls eine Dicke von 5 bis 25 nm. Die dritte, aus Ag bestehende Schicht, ist vorzugsweise 8 bis 18 nm dick. Die nachfolgende Schicht aus NiCrOₖ ist 3 bis 8 nm dick. Die letzte Schicht aus SiₓN_{y}O_{z} ist vorzugsweise 25 bis 65 nm dick.

**Tabelle 2**

| Vor dem Tempern | | Nach Tempern | | Differenz | |
|---|---|---|---|---|---|
| Ty | 82,25 | Ty | 83,58 | Ty | 1,33 |
| a* | -1,06 | a* | -1,63 | a* | -0,57 |
| b* | 1,93 | b* | 1,26 | b* | -0,67 |
| RGy | 9,95 | RGy | 9,63 | RGy | -0,32 |
| a* | -1,99 | a* | -0,35 | a* | 1,64 |
| b* | -5,70 | b* | -4,78 | b* | 0,92 |
| RFy | 6,43 | RFy | 6,95 | RFy | 0,52 |
| a* | -0,54 | a* | 0,82 | a* | 1,36 |
| b* | -5,36 | b* | -3,87 | b* | 1,49 |
| Haze | 0,16 | Haze | 0,33 | Haze | 0,17 |
| R/sq | 4,80 | R/sq | 3,30 | R/sq | -1,50 |

Man erkennt aus der Tabelle 2, dass es bei den wesentlichen Eigenschaften der Beschichtung vor und nach dem Tempern nur geringe Unterschiede gibt. Das Tempern wurde bei einer Temperatur von etwa 620 bis 700 °C durchgeführt. Dabei wurde das Substrat für 2 bis 20 Minuten aufgeheizt und dann mittels Druckluft sehr schnell gekühlt.

Die Haftfestigkeit wurde mittels des so genannten Erichsen Waschtests nach ISO 11998 geprüft. Sie war bei allen Proben einwandfrei. Auch die Lagerfähigkeit wurde getestet, und zwar nach dem so genannten Feuchtklimalagertest nach DIN EN ISO 6270 (DIN-50017). Auch hier wurden nur positive Werte ermittelt.

Außerdem liegt die Transmission Ty über 80 %, der Schichtwiderstand ist kleiner als 5,0 Ohm/sq und für die Farben in der Reflexion von der Glasseite gilt -4 < a* < 0 sowie -7 < b* < -2. Die Trübung ist kleiner als 0,5 %. Die mechanische Stabilität ist stabil, was mittels eines Erichson-Brushtests mit 200 Hüben festgestellt werden konnte.

## Patentansprüche

1. Temperbares, mit einer Beschichtung versehenes Substrat, **enthaltend**
1.1 Glas als Substrat
1.2 eine erste Schicht auf dem Glas aus SiₓN_{y}O_{z}
1.3 eine zweite Schicht aus TiO₂ auf der ersten Schicht
1.4 eine dritte Schicht aus Ag auf der zweiten Schicht
1.5 eine vierte Schicht aus NiCrOₖ auf der dritten Schicht
1.6 eine fünfte Schicht aus SiₓN_{y}O_{z} auf der vierten Schicht, wobei x/y ≤ 0,75 und y/z > 4 sowie 0 < k < 2.

2. Temperbares, mit einer Beschichtung versehenes Substrat nach Anspruch 1, **dadurch gekennzeichnet, dass** die erste Schicht Si₃N₄ ist.

3. Temperbares, mit einer Beschichtung versehenes Substrat nach Anspruch 1, **dadurch gekennzeichnet, dass** die fünfte Schicht Si₃N₄ ist.

4. Temperbares, mit einer Beschichtung versehenes Substrat nach Anspruch 1 und/oder Anspruch 2, **dadurch gekennzeichnet, dass** die Si₃N₄-Schichten einen Sauerstoffanteil Oₘ enthalten, wobei m zwischen 1 und 10⁻³ liegt.

5. Temperbares, mit einer Beschichtung versehenes Substrat nach Anspruch 1, **dadurch gekennzeichnet, dass** die vierte Schicht NiCr ist.

6. Temperbares, mit einer Beschichtung versehenes Substrat nach Anspruch 1, **dadurch gekennzeichnet, dass** die erste Schicht eine Dicke von ca. 5 bis 25 nm aufweist.

7. Temperbares, mit einer Beschichtung versehenes Substrat nach Anspruch 1, **dadurch gekennzeichnet, dass** die zweite Schicht eine Dicke von ca. 5 bis 25 nm aufweist.

8. Temperbares, mit einer Beschichtung versehenes Substrat nach Anspruch 1, **dadurch gekennzeichnet, dass** die dritte Schicht eine Dicke von ca. 8 bis 18 nm aufweist.

9. Temperbares, mit einer Beschichtung versehenes Substrat nach Anspruch 1, **dadurch gekennzeichnet, dass** die vierte Schicht eine Dicke von 3 bis 8 nm aufweist.

10. Temperbares, mit einer Beschichtung versehenes Substrat nach Anspruch 1, **dadurch gekennzeichnet, dass** die fünfte Schicht eine Dicke von 25 bis 65 nm aufweist.

11. Temperbares, mit einer Beschichtung versehenes Substrat nach Anspruch 6, **dadurch gekennzeichnet, dass** die erste Schicht eine Dicke von 15 nm aufweist.

12. Temperbares, mit einer Beschichtung versehenes Substrat nach Anspruch 7, **dadurch gekennzeichnet, dass** die zweite Schicht eine Dicke von 15 nm aufweist.

13. Temperbares, mit einer Beschichtung versehenes Substrat nach Anspruch 8, **dadurch gekennzeichnet, dass** die dritte Schicht eine Dicke von 12,5 nm aufweist.

14. Temperbares, mit einer Beschichtung versehenes Substrat nach Anspruch 9, **dadurch gekennzeichnet, dass** die vierte Schicht eine Dicke von 5 nm aufweist.

15. Temperbares, mit einer Beschichtung versehenes Substrat nach Anspruch 10, **dadurch gekennzeichnet, dass** die fünfte Schicht eine Dicke von 40 bis 50 nm aufweist.

16. Temperbares, mit einer Beschichtung versehenes Substrat nach Anspruch 1, **dadurch gekennzeichnet, dass** zwischen der TiO₂-Schicht und der Ag-Schicht eine Schicht zur Einstellung der Transmission vorgesehen ist.

17. Temperbares, mit einer Beschichtung versehenes Substrat nach Anspruch 16, **dadurch gekennzeichnet, dass** die Schicht zur Einstellung der Transmission transmissionserhöhend ist und aus 4 bis 20 nm ZnO besteht.

18. Temperbares, mit einer Beschichtung versehenes Substrat nach Anspruch 16, **dadurch gekennzeichnet, dass** die Schicht zur Einstellung der Transmission transmissionserhöhend ist und aus 5 bis 10 nm ZnO : A1 besteht.

19. Temperbares, mit einer Beschichtung versehenes Substrat nach Anspruch 16, **dadurch gekennzeichnet, dass** die Schicht zur Einstellung der Transmission transmissionsreduzierend ist und aus 1 bis 10 nm NiCr besteht.

20. Temperbares, mit einer Beschichtung versehenes Substrat nach Anspruch 16, **dadurch gekennzeichnet, dass** die Schicht zur Einstellung der Transmission transmissionsreduzierend ist und aus 2 bis 5 nm NiCrO besteht.

21. Verfahren zum Herstellen von Schichten nach Anspruch 1 mittels Sputtern, **dadurch gekennzeichnet, dass** bei der Herstellung der fünften Schicht das Verhältnis von N₂ zu O₂ größer oder gleich 4 : 1 ist.

22. Verfahren zum Herstellen von Schichten nach Anspruch 1 mittels Sputtern, **dadurch gekennzeichnet, dass** die mechanische Schichtspannung der Beschichtung durch Beeinflussung von Druck und Sauerstofffluss bei der Herstellung der SiₓN_{y}O_{z}-Einzelschicht einstellbar ist.

23. Verfahren zum Herstellen von Schichten nach Anspruch 1 mittels Sputtern, **dadurch gekennzeichnet, dass** der Arbeitsdruck bei Abscheidung der fünften Schicht im Bereich von 4,5 x 10⁻³ bis 15 x 10⁻³ mbar liegt.

24. Verfahren zum Herstellen von Schichten nach Anspruch 1 mittels Sputtern, **dadurch gekennzeichnet, dass** bei der Herstellung der ersten und fünften Schicht dem Sputterprozess eine Sauerstoffmenge zugeführt wird, die kleiner ist als die zugeführte Stickstoffmenge.
